(19) Europäisches Patentamt
European Patent Office
Office européen des brevets

(11) **EP 4 439 176 A1**

(12) **EUROPEAN PATENT APPLICATION**

(43) Date of publication:
**02.10.2024  Bulletin 2024/40**

(21) Application number: **23165332.0**

(22) Date of filing: **30.03.2023**

(51) International Patent Classification (IPC):
**G03F 7/00** *(2006.01)*    **G03F 9/00** *(2006.01)*

(52) Cooperative Patent Classification (CPC):
**G03F 7/70783; G03F 7/70633; G03F 7/7085;
G03F 9/7034; G03F 9/7092**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
• **OTTEN, Ronald, Henricus, Johannes
5500 AH Veldhoven (NL)**
• **WEI, Xiuhong
5500 AH Veldhoven (NL)**

(74) Representative: **ASML Netherlands B.V.
Corporate Intellectual Property
P.O. Box 324
5500 AH Veldhoven (NL)**

(54) **METHOD OF DETERMINING STRESSORS APPLIED TO A SUBSTRATE**

(57)     Disclosed is a method of determining the presence of stressors on a substrate. The method comprises obtaining substrate position data describing positional information of structures on the substrate in a substrate plane; obtaining substrate shape data describing a shape of the substrate; determining a first warp value from the substrate position data, the first warp value describing a warpage of the substrate; determining a second warp value from the substrate shape data, the second warp value describing the warpage of the substrate; and determining the presence of stressors on a back-side of the substrate based on the first warp value and second warp value.

Fig. 7

EP 4 439 176 A1

**Description**

BACKGROUND

Field of the Invention

The present invention relates to control apparatus and control methods usable, for example, to maintain performance in the manufacture of devices by patterning processes such as lithography. The invention further relates to methods of manufacturing devices using lithographic techniques. The invention yet further relates to computer program products for use in implementing such methods.

Related Art

A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself.

Stress and in-plane distortions of the substrate can result from one or more stress inducing layers being applied to the substrate. It may be desirable to determine the presence and/or quantify the effects of such stressors.

SUMMARY OF THE INVENTION

According to a first aspect of the present invention there is provided a method of determining the presence of stressors on a substrate, the method comprising:
obtaining substrate position data describing positional information of structures on the substrate in a substrate plane; obtaining substrate shape data describing a shape of the substrate; determining a first warp value from the substrate position data, the first warp value describing a warpage of the substrate; determining a second warp value from the substrate shape data, the second warp value describing the warpage of the substrate; and determining the presence of stressors on a back-side of the substrate based on the first warp value and second warp value.

According to a second aspect of the present invention there is provided a computer program product containing one or more sequences of machine-readable instructions for implementing calculating steps in a method according to the first aspect of the invention as set forth above

The invention yet further provides a processing arrangement and lithographic apparatus comprising the computer program of the second aspect.

These and other aspects and advantages of the apparatus and methods disclosed herein will be appreciated from a consideration of the following description and drawings of exemplary embodiments.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus suitable for use in an embodiment of the present invention;
Figure 2 depicts a lithographic cell or cluster in which an inspection apparatus according to the present invention may be used;
Figure 3 illustrates schematically measurement and exposure processes in the apparatus of Figure 1, according to known practice;
Figure 4 is a table illustrating four different scenarios for stressor application on a wafer;
Figure 5 is a schematic illustration of parameters which may be used to describe a stressor inhomogeneity;
Figure 6 is a flowchart describing a method according to an embodiment; and

Figure 7 illustrates a portion of a clamped wafer, schematically illustrating how an overlay correction may be determined from a warp measurement according to an embodiment.

DETAILED DESCRIPTION OF EXEMPLARY EMBODIMENTS

Before describing embodiments of the invention in detail, it is instructive to present an example environment in which embodiments of the present invention may be implemented.

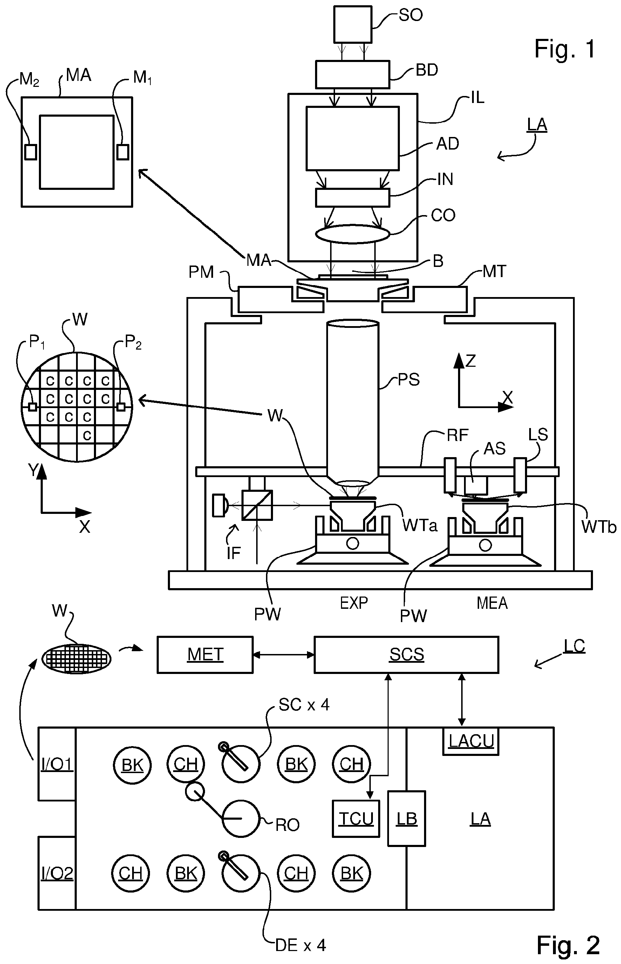

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables WTa and WTb (e.g., a substrate support or substrate/wafer table), each comprising a plurality of burls on a support surface and each constructed to hold a substrate (e.g., a resist coated wafer) W; and a projection system (e.g., a refractive projection lens system) PS configured to project a pattern imparted to the radiation beam B by patterning device MA onto a target portion C (e.g., including one or more dies) of the substrate W. Each substrate table may be connected to a second positioner PW configured to accurately position the substrate in accordance with certain parameters. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers, is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

The metrology step with metrology system MET can also be done after the resist pattern has been etched into a product layer. The latter possibility limits the possibilities for rework of faulty substrates but may provide additional information about the performance of the manufacturing process as a whole.

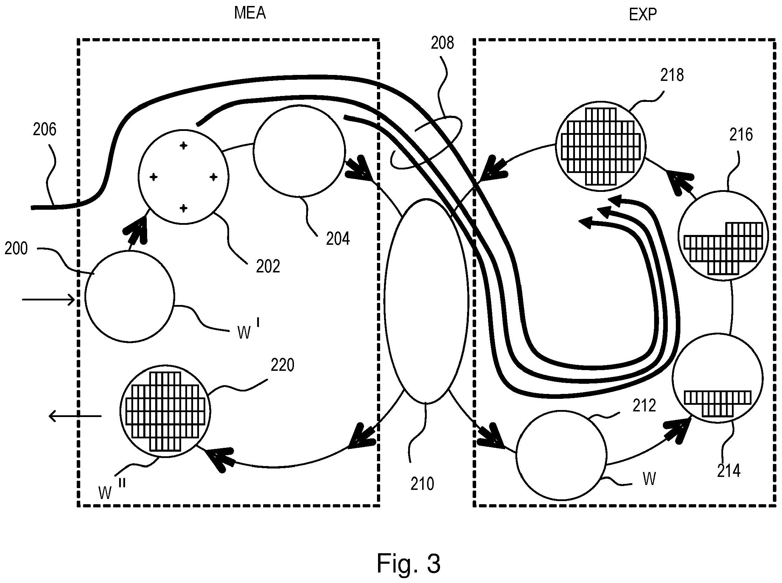

Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of lithographic apparatus, for example those having a single substrate stage and a docking metrology stage.

On the left hand side within a dotted box are steps performed at measurement station MEA, while the right hand side shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated lithographic apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

At step 204, a map of wafer height (Z) against X-Y position is measured also using the level sensor LS. Primarily, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. Where there is a choice of alignment marks on the substrate, and where there is a choice of settings of an alignment sensor, these choices are defined in an alignment recipe among the recipe data 206. The alignment recipe therefore defines how positions of alignment marks are to be measured, as well as which marks.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

One issue with present lithography and associated substrate processing techniques used in integrated circuit (IC) manufacture is a mechanical property such as in-plane deformation. One contributor to in-plane distortion may be the application of a stressor to the substrate; for example an applied layer or thin film deposition. Thin film stress typically has an impact on the unclamped, free-form shape of the substrate. This stressor results in a change or distortion of the substrate shape. Stressed thin films may produce a local overlay error (e.g. after resist development and/or after etching); such an overlay error often has high spatial frequency and may vary per substrate and across substrate. Sometimes, multiple such stressors may be applied. These stressors may be referred to as the front-side stressors (e.g., as they are applied to the front surface of the substrate on which patterns are being applied).

It is also known to apply back-side coatings or back-side stressors on the back-side of the substrate (i.e., the opposite side to the front-side and therefore the side clamped to the substrate table). Such back-side stressors may comprise compensatory back-side stressors, applied to compensate for the aforementioned front-side stressors, and therefore to help return the substrate to a flatter or flat shape; i.e., they can compensate for the (e.g., bowl) shape imposed on the substrate by the front-side stressors. Additionally or alternatively, back-side stressors may be applied to prevent contamination and protect the substrate and substrate table. Such back-side stressors may be applied in particular for critical layers; applying back-side stressors involves are large overhead and so is typically only performed when necessary rather than for every (front-side) layer.

It is sometimes necessary for a manufacturer of lithography and/or metrology machines to use data from their customers (e.g., production data) of which relatively little is known about the specific production steps applied to the substrates from which the data relates. Such data may be used in testing or development of machines, processes or software for example. In particular, for such (customer) production data, it is not always known whether front-side and/or back-side stressors have been applied, nor how many. It may be desirable to ascertain a processing history of such substrates from such data, the processing history describing the presence of such stressors. It may also be desirable (for either or both the manufacturer and customer) to determine or quantify the homogeneity of applied back-side stressors, e.g., to decide on which burl arrangements may be suitable and/or to improve the back-side stressor application process. It is also desirable to be able to quantify the impact of (e.g., back-side) stressors on a parameter of interest such as on-product overlay.

Substrate distortion, e.g., as resultant from said deposition of stressed thin films may impact overlay performance in a lithographic process. The free-form substrate shape, which can be measured with off-line metrology tools, may change as a result of this distortion. Typical shapes which may be observed in high volume manufacturing are bowl (convex), umbrella (concave), and saddle shapes. Deviations from these shapes result in higher order in-plane distortions.

In some cases, these in-plane distortions are slowly spatially varying functions that can be captured by existing alignment models, such as (for example) high order wafer alignment (HOWA) models. An important precondition is that the grid distortions remain global as the polynomial-based HOWA models become less effective for very local distortions. Another approach is to use substrate shape or deformation measurements. Such substrate shape measurements may comprise out-of-plane deformation measurements; i.e., measurements of the shape of the substrate in the z-direction, normal to the substrate surface plane. The substrate shape measurements may comprise measurements of the free-form (unclamped) substrate shape. Any reference to the substrate shape or wafer shape encompasses any suitable measurement of the out-of-plane deformation of the substrate by any of these, or other, methodologies. Where the relationship between free-form substrate shape and in-plane distortion (IPD) after clamping is known or can be modelled, predictions (and corrections) can be made to improve overlay performance.

It is sometimes desirable to determine the substrate warp between the final burl (i.e., in a radial direction outwards from the center) and the edge of the substrate, which may be referred to as edge roll-off. Burls are (e.g., cylindrical) protrusions or bumps on a support surface of a substrate support or substrate table. Burls limit the contact surface between clamp and substrate thereby reducing substrate back-side particle contamination. Substrate flatness is provided and maintained through the extreme surface finish of the top of the burls, a small burl pitch of a few millimeters, and high (e.g., vacuum or electrostatic) clamping forces.

However, the performance of known methods is not predictable, and errors are introduced. The use of stressors causes the substrate to warp and results in in-plane distortions after clamping of the substrate on the substrate table. In order to compensate for substrate warpage, further stress layers may be applied on the substrate back-side, which further impacts in-plane distortion and edge roll-off, increasing the overlay. As has been described, clamping the substrate helps flatten the substrate, and therefore reduce overlay penalty from edge roll-off. However this can result in the in-plane distortion becoming twice as large resulting in a high overlay penalty.

One solution which can reduce the effect of edge roll-off is to move outermost burl further outwards, closer to the substrate edge. However, such an approach is only feasible if the distortion or warp is sufficiently homogeneous all the way to the proposed outermost burl position; very high substrate-table wear is typically seen if this is not the case, resulting in unacceptable downtime. Therefore, it is further desirable to be able to determine the homogeneity of any (e.g., back-side) layer deposition and/or distortion and therefore the feasibility of using burls nearer the substrate edge. This distortion homogeneity is dependent on the homogeneity of the applied back-side stressors, which may be inhomogeneous near the edge (particularly when applied for contamination prevention) due to processing issues.

It is proposed to use a combination of levelling data (substrate shape data) and alignment or overlay data (substrate position data) to determine the presence and/or uniformity/homogeneity of applied stressors. In some embodiments, the impact of these stressors on a parameter of interest such as overlay may be quantified. Such a method may comprise determining free-form substrate warpage respectively from both substrate shape data/levelling data and substrate position data/alignment data.

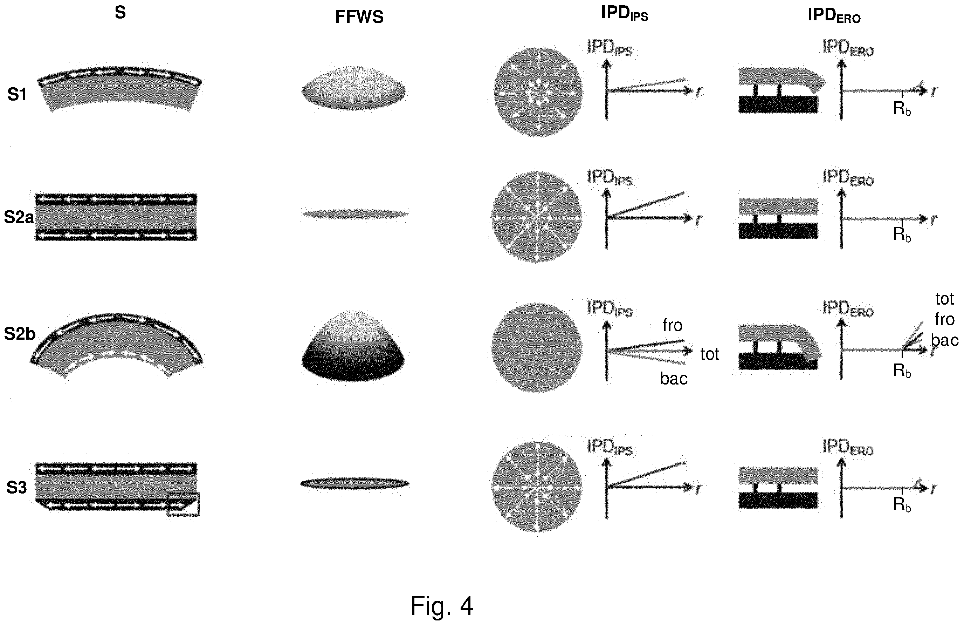

Figure 4 illustrates the various processing scenarios S that a substrate may be subjected to, the resultant free-form wafer shape FFWS, the (clamped) in-plane distortion resultant from in-plane stress $IPD_{IPS}$ and the (clamped) in-plane distortion resultant from edge roll-off $IPD_{ERO}$. The latter two columns show these distortion parameters plotted against radial distance from substrate center $r$.

The top row describes a first scenario S 1, in which only a front-side compressive stressor has been applied. This front-side only stress results in an umbrella-shaped substrate. After clamping, the resulting in-plane distortion from in-plane stress $IPD_{IPS}$ shows a linear relationship or scaling (symmetric magnification) with radial position r. The resulting edge roll-off $IPD_{ERO}$ shows a remainder of the free-form shape beyond the final burl, comprising a positive radial distortion at the substrate edge.

Scenario 2a shows a first scenario where the substrate has been subject to homogeneous front-side and homogeneous back-side deposition. In this example, the applied front-side and back-side stress are both compressive. The applied stress to the substrate back-side makes the substrate shape FFWS flat again and the resulting edge roll-off $IPD_{ERO}$ zero; however the radial scaling is now twice as large as in scenario S1 (but still has a linear relationship with radial position).

Scenario 2b shows a second scenario where the substrate has been subject to homogeneous front-side and homogeneous back-side deposition; in this case the applied stresses are opposite front-side and back-side, which may sometimes be encountered when a back-side stressor is applied for contamination mitigation. As such, a back-side tensile stress is applied to the substrate in combination with a compressive front-side stress. In this scenario, the IPD from edge roll-off $IPD_{ERO}$ is larger than with the front-side stress only, but the resulting IPD from in-plane stress $IPD_{IPS}$ is zero (in both cases, the front fro, back bac and total tot IPD is shown plotted separately).

Scenario 3 shows compressive front-side and compressive back-side deposition, but where (at least) the back-side deposition is inhomogeneous. The results is an almost flat substrate, having some edge roll-off, and where the IPD from in-plane stress $IPD_{IPS}$ is not completely linear, having a non-linear component near the edge. Other than this, similarly to scenario 2a, the magnitude of the in-plane stress $IPD_{IPS}$ is about twice that of the in-plane stress $IPD_{IPS}$ of scenario 1. In contrast to scenario 2a, the IPD from edge roll-off $IPD_{ERO}$ now comprises an additional component from the inhomogeneous processing.

The proposed methods may comprise determining a first warp value, e.g., the substrate warp from in-plane stress $warp_{IPS}$, and a second warp value, e.g., the in-plane distortion from edge roll-off $warp_{ERO}$. The first warp value may be determined from alignment data as measured via an alignment sensor (or alternatively overlay data or other similar position data relating to position in the substrate plane) and the second warp value may be determined from leveling data (substrate shape data) as measured via a leveling sensor.

It can be appreciated from Figure 4 that back-side layers have a different effect on IPD from in-plane stress than on IPD from edge roll-off: More specifically, the total contribution to IPD from in-plane stress is the sum of the displacements as imposed on substrate front-side and substrate back-side while the total contribution to IPD from edge roll-off is the difference of the IPDs as imposed on substrate front-side and substrate back-side. The proposed method uses this difference in effect on IPD to determine the presence of back-side stress, and more specifically uses a comparison of predicted warp values based on alignment data and on leveling edge roll-off (curl up/down) data.

With respect to the first warp value, this can be determined more specifically from an alignment magnification value (e.g., a symmetric substrate scaling $Mws$[ppm] value). Prior to every substrate exposure, alignment marks on the substrate may be measured by the alignment sensor in the scanner, in a process referred to as Fine Wafer Alignment (FIWA). These are used to determine substrate displacements with respect to the expected positions and to calculate corrections. For these measurements a number of marks are selected, for example in a circular pattern. Based on measurements the displacements in any location on the substrate can be predicted. The simplest model used to represent the alignment data is a linear 4 parameter model that describes the displacement in terms of translation, magnification and rotation. Each measured displacement ($dx$, $dy$) per alignment mark at a location ($xc$, $yc$) an be represented as:

$$dx = Mws * xc - Rws * yc + Tx$$

$$dy = Rws * xc + Mws * yc + Ty$$

where $Tx$, $Ty$ are the translations in x and y, $Mws$ is the symmetric substrate scaling and $Rws$ is the symmetric rotation. The parameter values can be calculated, for example, via least square fit to the data for all marks. Alignment models may comprise additional parameters than these four (e.g., a 6-parameter model, or various higher-order models are often used), however all alignment models will typically comprise at least these four parameters. The resulting parameters can be obtained from a scanner logging file after exposure.

Assuming homogeneous stressors, there is a linear relationship between parabolic substrate warpage (warp$_{IPS}$ [$\mu$m]) and linear scaling IPD, with the gradient (proportionality constant) dependent on substrate parameters (specifically substrate height and radius, and will therefore be essentially a constant where these parameters are standardized). As such, the warp can be predicted from the symmetric substrate scaling. The proposed equation can be derived from application of the gradient (Stoney) model for the in-plane distortion $\mathrm{IPD}(r) = -\frac{h_w}{6}\frac{dw}{dr}$, where $h_w$ is the substrate thickness and w($r$) is the substrate shape as a function of the radial coordinate $r$, to a parabolic shape w($r$) = warp$_{IPS}$ $\frac{r^2}{R^2}$ and evaluating the IPD at the substrate edge $r = R$:

$$\mathrm{IPD}(r) = -\frac{h_w}{3}\mathrm{warp}_{IPS}\frac{r}{R^2}$$

$$\mathrm{IPD}(R) = -\frac{h_w}{3}\mathrm{warp}_{IPS}\frac{1}{R}$$

$$Mws = \frac{\mathrm{IPD}(R)}{R} = -\frac{h_w}{3R^2} * \mathrm{warp}$$

$$\mathrm{warp}_{IPS} = -\frac{3R^2}{h_w} * Mws$$

as such, for a parabolic shape, the Gradient model accurately predicts the linear scaling IPD.

It can be appreciated that using this first warp value alone may result in an overestimation of the substrate warp since the presence of a back-side coating might introduce more stress in the substrate and larger magnification, but reduce the substrate warp.

The second warp value may comprise using leveling data to predict the edge roll-off warp, which describes the warp of the clamped substrate between the final burl and the substrate edge. Between the substrate center and the final burl, the substrate will be clamped flat (as is apparent for all scenarios from the last column of Figure 4). The leveling data or local leveling profile w($r$) used in this embodiment may comprise a difference between two layers (a delta local leveling profile) in order to cancel out the effect substrate table unflatness (wear) and burls. For a uniform front-side (and or) back-side coating, the local leveling profile $w(r)$ beyond the final burl can be written as $w(r) = \text{warp}_{\text{ERO}} \frac{(r - R_b)^2}{R^2}$,
where r is the radial coordinate, $R$ the substrate radius and $R_b$ the radial coordinate of the final burl. Therefore the warp based on leveling data can be computed as :

$$\text{warp}_{\text{ERO}} = \frac{R^2}{(r - R_b)^2} * w(r)$$

To estimate this warp as a single value, a least-squares fit of $w(r) \frac{R^2}{(r - R_b)^2}$ for $r > R_b$ can be made.

These warp values may be used together to ascertain the processing history. For example, if $\text{warp}_{\text{ERO}} = \text{warp}_{\text{IPS}}$, it can be assumed that there is one-sided deposition only (homogeneous), and therefore no back-side deposition. This is more likely to be the case with certain calibration, matching or set-up substrates than actual product substrates.

For both scenarios 2a and 2b, $\text{warp}_{\text{ERO}} \neq \text{warp}_{\text{IPS}}$ and there is homogeneous front-side and back-side deposition such that the displacement only depends on the radius r. It can be assumed that the front-side and back side deposition result in respective independent warp contributions to the total substrate warp. It can further be understood that:

$$\text{warp}_{\text{IPS}} = \text{warp}_{\text{FS}} + \text{warp}_{\text{BS}} = -\frac{3R^2}{h_w} * Mws$$

$$\text{warp}_{\text{ERO}} = \text{warp}_{\text{FS}} - \text{warp}_{\text{BS}} = \frac{R^2}{(r - R_b)^2} * w(r)$$

where the subscript FS indicates front-side warp (i.e., warp induced by front-side stressors only) and subscript BS indicates back-side warp (i.e., warp induced by back-side stressors only). From these two equations, the two unknowns $\text{warp}_{\text{FS}}$ and $\text{warp}_{\text{BS}}$ can be individually determined. Therefore the impact of the back-side stressors can be quantified.

Scenario 3 describes front-side and inhomogeneous back-side deposition. The warp caused by front-side and back-side coating can be determined from leveling and alignment data in a similar method to that described for scenario 2; however the warp $\text{warp}_{\text{IPS}}$ based on leveling data now comprises an additional component $\text{warp}_{\delta\text{in}}$ resulting from the inhomogeneous processing, which can be assumed to be on the substrate back-side:

$$\text{warp}_{\text{IPS}} = \text{warp}_{\text{FS}} + \text{warp}_{\text{BS}} = -\frac{3R^2}{h_w} * Mws$$

$$\text{warp}_{\text{ERO}} = \text{warp}_{\text{FS}} - \text{warp}_{\text{BS}} + \text{warp}_{\delta\text{in}} = \frac{R^2}{(r - R_b)^2} * w(r)$$

In this case, it can be determined whether the calculated warp matches the warpage based on the Stoney equation: if the material parameters are known, the stress $\sigma$ in a homogeneous layer can be computer from the Stoney equation:

$$\sigma = \frac{E_s h_w^2 \kappa}{6 h_f (1 - v_s)}$$

where $\sigma$ is the stress in the layer, $E_s$ is the Young's modulus of the substrate, $h_w$ is the substrate thickness, $\kappa = \frac{d^2 w}{dr^2}$ is the substrate and layer curvature, $h_f$ is the film thickness, and $v_s$ is the Poisson ratio of the substrate. In this case the stress and curvature are constant values, which for the shape means that it is a perfect parabola.

If this is not the case, then a training mechanism may be used to train the model. To do this, a lookup table may be constructed from FEM simulations. For these simulations, the following modified physical model may be used, as for a non-uniform stress the standard Stoney model is no longer valid:

$$\sigma(x,y) = \frac{E_s h_w^2}{6 h_f (1 - v_s)} \left( \kappa(x,y) + \frac{1 - v_s}{1 + v_s} \left( \kappa(x,y) - \bar{\kappa} \right) \right)$$

where $\bar{\kappa}$ is the average curvature of the substrate. For this case the stress and curvature are no longer constant but depend on the location (x, y) on the substrate. This equation is valid for axisymmetric stress distributions, i.e., only dependent on the radial coordinate r. For the general case there is an additional term between the large brackets which depends on the radial coordinate and the polar coordinate (angle) phi.

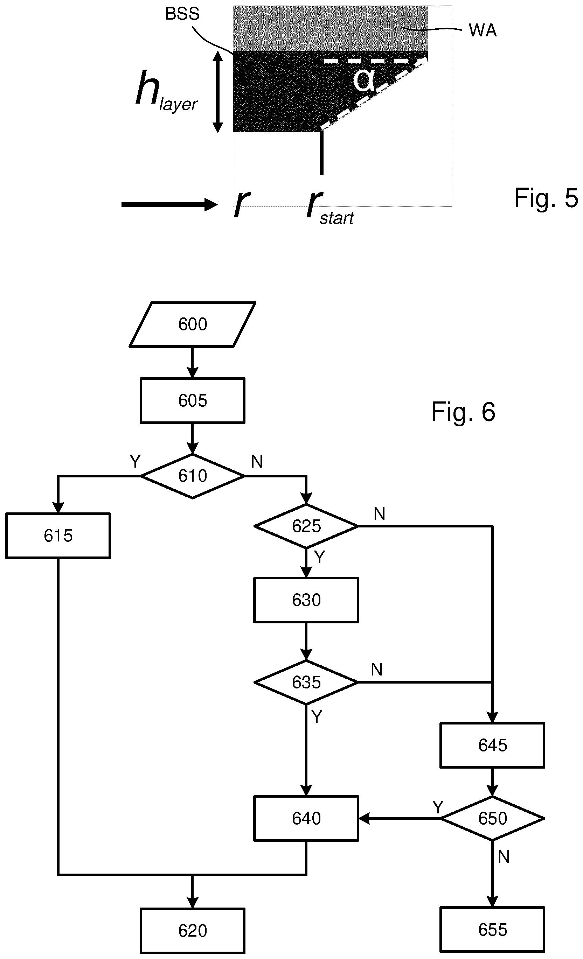

A method for constructing the proposed look-up table will now be described, in combination with Figure 5. Figure 5 shows a detail (e.g., within the box shown in Figure 4, column 1 for scenario 3) of substrate W at the edge. The figure shows a portion of the substrate W and inhomogeneous back-side stressor BSS. Using Finite Element simulations, the effect on the in-plane distortions can be determined for different back-side layer non-uniformities. Each back-side layer non-uniformity at the substrate edge layer can be characterized by the following inhomogeneity parameters:

- The layer thickness before the decrease in thickness (inhomogeneity) begins $h_{layer}$
- The radial position $r_{start}$ where the thickness decrease begins; and
- The slope of the decrease, which is characterized by an angle α.

By running the simulations for different values of these parameters, the look-up table can be created. As such, the input to the simulation may comprise these three parameters describing the profile, or a function describing the profile. The output of the simulation may be the in-plane and out-of-plane distortions. The out-of-plane distortion may be converted into a levelling profile, and the in-plane distortion into overlay/alignment. For each coordinate, a different wafer warp can be determined using the extended Stoney equation.

Figure 6 is a flowchart describing a method according to an embodiment. The method comprises determining which of the above scenarios a substrate has been subjected to from alignment and leveling data. This may be used to determine whether the outermost burl may be moved closer to the edge, which is allowable for scenario 1, 2a and 2b, where distortion is homogenous, but not for scenario 3, where distortion is inhomogeneous.

Substrate position data or alignment data (more specifically symmetric magnification data) and substrate shape data or leveling data 600 is obtained, e.g., from measurement of a substrate using an alignment sensor and leveling sensor respectively. Typically, such data will be measured for each substrate routinely as part of known alignment and leveling metrology. In a calculation step 605, a first warp value warp$_{IPS}$ is determined from the alignment data and a second warp value warp$_{ERO}$ is determined from the leveling data, using the methods and relationships described. At step 610, it is determined whether the first warp value warp$_{IPS}$ and second warp value warp$_{ERO}$ are equal (or at least substantially equal within a threshold margin). If yes Y, then scenario 1 (the substrate has a stressor on one side only) may be concluded 615; if there is only one-sided deposition (homogeneous), then the first warp value warp$_{IPS}$ will equal the second warp value warp$_{ERO}$. As such, it can be concluded 620 that the outermost burl can be located further towards the edge (e.g., beyond 145mm, beyond 146mm beyond 147mm or at or beyond 148mm from the substrate table center). This step may further comprise determining an overlay correction for edge roll-off based on the second warp value warp$_{ERO}$.

Step 620 may also comprise determining the in-plane (xy) stress contribution from the alignment data via:

$$IPD_{xy} = Mws \cdot r$$

and the out-of-plane (z) contribution from the levelling data via:

$$IPD_Z = -\frac{h_w}{2} \frac{dw}{dr}$$

This is possible for scenarios 1 and 2 but not scenario 3.

If the determination at step 610 is no N, then at step 625 it may be determined whether the designed layer thickness and actual layer thickness known. If yes Y, the scenario 2 (scenarios 2a and 2b) equations may be applied 630, followed by a determination 635 as to whether the actual layer thickness is the same as the designed thickness. If yes Y, then it can be assumed that the back-side layer is homogenous 640 (scenario 2a or 2b) and the method continues to step 620 as has already been described (e.g., the outermost burl may be moved and/or in-plane and/or out-of-plane distortions determined).

If the either determination 625, 635 is no N, then the scenario 3 equations are applied 645 based on the look-up table to determine the additional warp component $warp_{\delta in}$ resulting from the inhomogeneous processing.

At step 650, it is assessed whether the additional warp component $warp_{\delta in}$ is smaller than a threshold tolerance indicative of inhomogeneity. If no N, then scenario 3 is assumed 655 and it may be decided to locate the final burl at a position away from the edge (e.g., less than 145mm from the center, or less than 144.5mm, e.g., at 144mm). Such a determination may also be used to prompt investigation into why the back-side deposition is inhomogeneous and/or to amend the back-side deposition processing to improve homogeneity (or even to decide not to apply back-side stressors for one or more problematic layers).

If the determination at step 650 is yes Y, then it can be assumed that the back-side layer is homogenous 640 (scenario 2a or 2b) and the method continues to step 620 as has already been described (e.g., the outermost burl may be moved and/or in-plane and/or out-of-plane distortions determined).

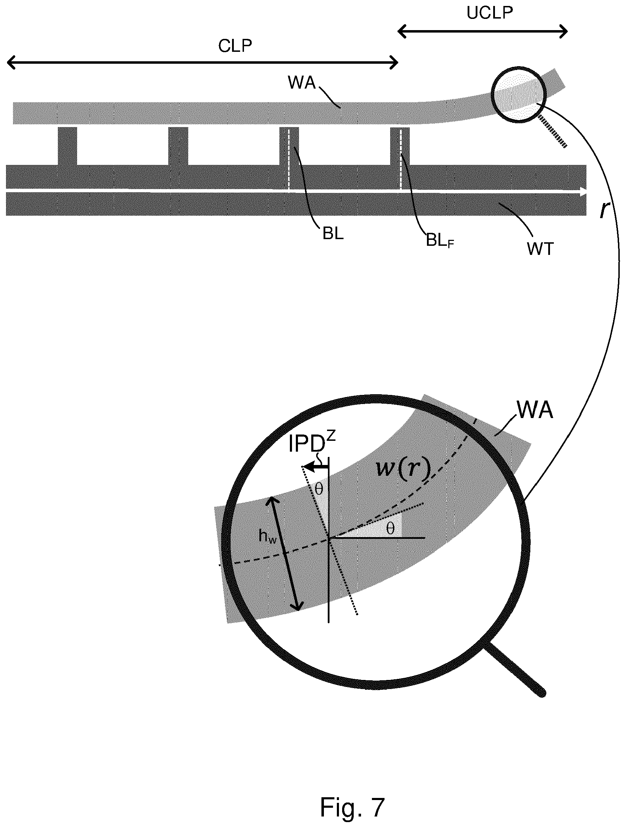

Figure 7 is an illustration of the effect of edge roll-off. It shows a portion of a substrate WA on a substrate table WT comprising burls BL, one of the burls comprising a final burl BLF as has been described. The radial position of the final burl $BL_F$ defines a boundary between a clamped portion CLP of the substrate and unclamped portion UCLP of the substrate WA.

As has been mentioned, in an embodiment, an overlay correction may be calculated from the measured warp (e.g., the first warp value $warp_{IPS}$, e. g., noting that $\frac{dw}{dr} = warp_{IPS}\frac{2r}{R^2}$ ). Beyond the final burl $BL_F$ of the substrate table WT, the leveling map shows a remainder of the substrate warp. The substrate is clamped to last burl with local bending maintained in unclamped region. Edge distortion is determined by substrate shape only. The distortion should be similar for various warp levels and on different substrate tables (e.g., assuming a similar burl layout). The local angle $\theta$ from the out-of-plane deflection translates into an out-of-plane displacement $IPD_Z$ according to:

$$\theta = \frac{dw}{dr}$$

$$IPD_Z = -\frac{h_w}{2} \times \theta$$

$$IPD_Z = -\frac{h_w}{2}\frac{dw}{dr}$$

Furthermore, in-plane (xy) stress contribution can be determined from the alignment data via:

$$IPD_{xy} = Mws \cdot r$$

This in-plane and out-of-plane displacement can be used to determine overlay and therefore an overlay correction can be determined which compensates for these displacements.

The above calculations for $IPD_Z$ and $IPD_{xy}$ are only applicable to scenarios 1 and 2 (2a or 2b). For scenario 3, an overlay correction may use a different approach, e.g., using the extended Stoney equation and/or via the lookup table.

As such, methods are disclosed herein which enable quantification of back-side deposition uniformity, e.g., using a scanner as inspection tool without having to perform additional metrology. As such, the disclosed methods enable the replacement of frequent offline measurements such as substrate-shape measurements. For example, the proposed method enables substrate-shape feedforward for the substrate edge with only scanner input. The proposed method enables also enables the determination of the effect of in-plane distortions at the substrate edge in addition to leveling information. The method enables a pre-judgement as to whether an outermost burl can move closer to the edge.

In association with the hardware of the lithographic apparatus and the lithocell LC, an embodiment may include a computer program containing one or more sequences of machine-readable instructions for causing the processors of the lithographic manufacturing system to implement methods of model mapping and control as described above. This computer program may be executed for example in a separate computer system employed for the image calculation/control process. Alternatively, the calculation steps may be wholly or partly performed within a processor a metrology tool, and/or the control unit LACU and/or supervisory control system SCS of Figures 1 and 2. There may also be provided a data storage medium (e.g., semiconductor memory, magnetic or optical disk) having such a computer program stored therein in non-transient form.

Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

Further embodiments have been disclosed in the following list of numbered clauses:

1. A method of determining the presence of stressors on a substrate, the method comprising:

obtaining substrate position data describing positional information of structures on the substrate in a substrate plane;
obtaining substrate shape data describing a shape of the substrate;
determining a first warp value from the substrate position data, the first warp value describing a warpage of the substrate;
determining a second warp value from the substrate shape data, the second warp value describing the warpage of the substrate; and
determining the presence of stressors on a back-side of the substrate based on the first warp value and second warp value.

2. A method according to clause 1, comprising determining the presence of stressors on a back-side of the substrate based on a comparison of the first warp value and second warp value.

3. A method according to clause 1 or 2, comprising determining that the substrate comprises no back-side stressor on the back-side of the substrate when said the first warp value and second warp value are substantially equal.

4. A method according to any preceding clause, comprising determining that the substrate comprises at least one back-side stressor when the first warp value and second warp value are not substantially equal.

5. A method according to clause 4, further comprising determining a value for a warp component resulting from inhomogeneous processing; and
determining whether said at least one back-side stressor is homogenous or inhomogeneous based on a magnitude of said warp component.

6. A method according to clause 5, comprising comparing said value for the warp component to a threshold value; and determining said at least one back-side stressor is homogeneous if said value for the warp component is smaller than the threshold value and said at least one back-side stressor is inhomogeneous if said value for the warp component is equal or larger than the threshold value.

7. A method according to clause 5 or 6, comprising determining an outermost burl position based on the presence or not of a an inhomogeneous back-side stressor.

8. A method according to clause 7, wherein the outermost burl position is determined to be 145mm or more from a center of the substrate when it is determined that there is no inhomogeneous back-side stressor.

9. A method according to clause 7, wherein the outermost burl position is determined to be 147mm or more from a center of the substrate when it is determined that the substrate comprises no inhomogeneous back-side stressor.

10. A method according to clause 7, 8 or 9, wherein the outermost burl position is determined to be less than 145mm from a center of the substrate when it is determined that the substrate comprises at least one inhomogeneous back-side stressor.

11. A method according to any of clauses 5 to 10, comprising determining values for a front-side warp contribution and a back-side warp contribution from said first warp value, said second warp value, the substrate position data and said substrate shape data.

12. A method according to clause 11, wherein said values for a front-side warp contribution and a back-side warp contribution are determined by solving for said front-side warp contribution and a back-side warp contribution a first equation equating said first warp value to a sum of at least said front-side warp contribution and said back-side warp contribution and a second equation equating said second warp value to a difference of said front-side warp contribution and back-side warp contribution.

13. A method according to clause 12, wherein said first equation comprises an additional term comprising said warp component resulting from inhomogeneous processing, when said warp component is above said threshold value.

14. A method according to clause 13, wherein said solving step is performed with reference to a look-up table describing the effect of one or more inhomogeneity parameters on stress within and/or distortion of the substrate.

15. A method according to clause 14, wherein said inhomogeneity parameters comprise one or more of:

the layer thickness before any inhomogeneity begins;
the radial position where said inhomogeneity begins; and
the slope of a decrease in said layer thickness characterizing the inhomogeneity.

16. A method according to any preceding clause, comprising wherein said substrate position data comprises alignment data.

17. A method according to clause 16, wherein said alignment data comprises symmetric substrate scaling data.

18. A method according to clause 17, wherein said step of determining a first warp value assumes a substantially linear relationship between said symmetric substrate scaling data and said first warp value.

19. A method according to any preceding clause, wherein said substrate shape data comprises leveling data.

20. A method according to clause 19, wherein said leveling data comprises a local leveling profile between the radial position of the final burl and an edge of the substrate.

21. A method according to any preceding clause, further comprising determining an overlay correction from said first warp value.

22. A method according to any preceding clause, wherein said stressor comprises an applied stressor layer which stresses and deforms the substrate.

23. A method according to any preceding clause, comprising measuring said substrate to obtain said substrate position data and substrate shape data.

24. A computer program comprising program instructions operable to perform the method of any preceding clause, when run on a suitable apparatus.

25. A non-transient computer program carrier comprising the computer program of clause 24.

26. A processing arrangement comprising:

a computer program carrier comprising the computer program of clause 24; and
a processor operable to run said computer program.

27. A lithographic apparatus comprising the processing arrangement of clause 26.

28. A lithographic apparatus according to clause 27, further comprising:

an alignment sensor operable to measure a substrate to obtain said substrate position data; and
a leveling sensor operable to measure a substrate to obtain said substrate shape data.

29. A lithographic apparatus according to clause 27 or 28, further comprising:
a substrate support for supporting said substrate, said substrate support comprising a plurality of burls on a support surface.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A method of determining the presence of stressors on a substrate, the method comprising:

obtaining substrate position data describing positional information of structures on the substrate in a substrate plane;

obtaining substrate shape data describing a shape of the substrate;

determining a first warp value from the substrate position data, the first warp value describing a warpage of the substrate;

determining a second warp value from the substrate shape data, the second warp value describing the warpage of the substrate; and

determining the presence of stressors on a back-side of the substrate based on the first warp value and second warp value.

2. A method as claimed in claim 1, comprising determining the presence of stressors on a back-side of the substrate based on a comparison of the first warp value and second warp value.

3. A method as claimed in claim 1 or 2, comprising determining that the substrate comprises no back-side stressor on the back-side of the substrate when said the first warp value and second warp value are substantially equal.

4. A method as claimed in any preceding claim, comprising determining that the substrate comprises at least one back-side stressor when the first warp value and second warp value are not substantially equal.

5. A method as claimed in claim 4, further comprising determining a value for a warp component resulting from inhomogeneous processing; and

determining whether said at least one back-side stressor is homogenous or inhomogeneous based on a magnitude of said warp component.

6. A method as claimed in claim 5, comprising comparing said value for the warp component to a threshold value; and determining said at least one back-side stressor is homogeneous if said value for the warp component is smaller than the threshold value and said at least one back-side stressor is inhomogeneous if said value for the warp component is equal or larger than the threshold value.

7. A method as claimed in claim 5 or 6, comprising determining an outermost burl position based on the presence or not of a an inhomogeneous back-side stressor.

8. A method as claimed in any of claims 5 to 7, comprising determining values for a front-side warp contribution and a back-side warp contribution from said first warp value, said second warp value, the substrate position data and said substrate shape data.

9. A method as claimed in claim 8, wherein said values for a front-side warp contribution and a back-side warp contribution are determined by solving for said front-side warp contribution and a back-side warp contribution a first equation equating said first warp value to a sum of at least said front-side warp contribution and said back-side warp contribution and a second equation equating said second warp value to a difference of said front-side warp contribution and back-side warp contribution.

10. A method as claimed in claim 9, wherein said first equation comprises an additional term comprising said warp component resulting from inhomogeneous processing, when said warp component is above said threshold value.

11. A method as claimed in claim 10, wherein said solving step is performed with reference to a look-up table describing the effect of one or more inhomogeneity parameters on stress within and/or distortion of the substrate.

12. A method as claimed in claim 11, wherein said inhomogeneity parameters comprise one or more of:

the layer thickness before any inhomogeneity begins;

the radial position where said inhomogeneity begins; and

the slope of a decrease in said layer thickness characterizing the inhomogeneity.

13. A method as claimed in any preceding claim, comprising wherein said substrate position data comprises alignment data.

14. A method as claimed in any preceding claim, wherein said substrate shape data comprises leveling data.

15. A computer program comprising program instructions operable to perform the method of any preceding claim, when run on a suitable apparatus.

Fig. 1

Fig. 2

Fig. 3

Fig. 4

Fig. 5

Fig. 6

Fig. 7

**EUROPEAN SEARCH REPORT**

Application Number

EP 23 16 5332

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2017 075072 A (SUMITOMO ELECTRIC INDUSTRIES) 20 April 2017 (2017-04-20)<br>* abstract *<br>* figures 1-3 *<br>* paragraphs [0011], [0020], [0021], [0022], [0029] * | 1-15 | INV.<br>G03F7/00<br>G03F9/00 |
| A | US 2021/320036 A1 (JAIN NIKHIL [US] ET AL) 14 October 2021 (2021-10-14)<br>* abstract *<br>* figure 2 *<br>* paragraphs [0001], [0043] – [0052] * | 1-15 | |
| A | US 2021/066139 A1 (HO WEI-DE [TW] ET AL) 4 March 2021 (2021-03-04)<br>* abstract *<br>* figure 1 *<br>* paragraphs [0002], [0032], [0037] – [0043] * | 1-15 | |

TECHNICAL FIELDS
SEARCHED (IPC)

G03F

The present search report has been drawn up for all claims

| Place of search | Date of completion of the search | Examiner |
|---|---|---|
| Munich | 29 August 2023 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 5332

This annex lists the patent family members relating to the patent documents cited in the above-mentioned European search report.
The members are as contained in the European Patent Office EDP file on
The European Patent Office is in no way liable for these particulars which are merely given for the purpose of information.

29-08-2023

| Patent document cited in search report | | Publication date | Patent family member(s) | | Publication date |
|---|---|---|---|---|---|
| JP 2017075072 A | | 20-04-2017 | JP | 6964388 B2 | 10-11-2021 |
| | | | JP | 2017075072 A | 20-04-2017 |
| US 2021320036 A1 | | 14-10-2021 | NONE | | |
| US 2021066139 A1 | | 04-03-2021 | CN | 112447540 A | 05-03-2021 |
| | | | TW | 202109696 A | 01-03-2021 |
| | | | US | 2021066139 A1 | 04-03-2021 |
| | | | US | 2022359313 A1 | 10-11-2022 |

EPO FORM P0459

For more details about this annex : see Official Journal of the European Patent Office, No. 12/82